# EUROPEAN PATENT SPECIFICATION

(11) **EP 1 576 262 B1**
(45) Date of publication and mention of the grant of the patent: **29.11.2006**
(21) Application number: 03789576.0
(22) Date of filing: 23.12.2003
(51) Int. Cl.: F01N 5/02, F02G 5/02, H01L 35/00

(54) **EXHAUST HEAT POWER GENERATION APPARATUS**
VORRICHTUNG ZUR ENERGIEERZEUGUNG VON ABGASWÄRME
APPAREIL DE PRODUCTION D'ENERGIE THERMIQUE DE GAZ D'ECHAPPEMENT

(30) Priority: 26.12.2002 JP 2002377862; 08.01.2003 JP 2003002338
(43) Date of publication of application: 21.09.2005
(73) Proprietor: Toyota Jidosha Kabushiki Kaisha, Toyota-shi, Aichi-ken, 471-8571 (JP)
(72) Inventor: MURATA, Kiyohito, c/o Toyota Jidosha K.K., Toyota-shi, Aichi-ken, 471-8571 (JP)
(74) Representative: Winter, Brandl, Fürniss, Hübner Röss, Kaiser, Polte Partnerschaft Patent- und Rechtsanwaltskanzlei
(86) International application number: PCT/IB2003/006162
(87) International publication number: WO 2004/059138

(56) References cited:
- FR-A- 2 512 499
- US-A- 5 917 144
- PATENT ABSTRACTS OF JAPAN vol. 1999, no. 09, 30 July 1999 (1999-07-30) & JP 11 122960 A (CALSONIC CORP;NISSAN MOTOR CO LTD), 30 April 1999 (1999-04-30)
- PATENT ABSTRACTS OF JAPAN vol. 1999, no. 05, 31 May 1999 (1999-05-31) & JP 11 036981 A (NISSAN MOTOR CO LTD;CALSONIC CORP), 9 February 1999 (1999-02-09) cited in the application

## Description

### BACKGROUND OF THE INVENTION

### 1. Field of Invention

The invention relates to an exhaust heat power generation apparatus that converts thermal energy of exhaust gas into electric energy.

### 2. Description of Related Art

An exhaust heat power generation apparatus has been developed to collect energy from the exhaust gas discharged from an engine by converting the thermal energy of the exhaust gas into electric energy. In the exhaust heat power generation apparatus, a thermoelectric converting module is interposed between an exhaust pipe (high temperature side) through which the exhaust gas flows and a cooling unit (low temperature side). Each thermoelectric element of the thermoelectric converting module functions in generating power in accordance with the temperature difference between the high temperature side and the low temperature side (Related Art: JP-A-11-36981; Figs. 3 to 5). Thermoelectric conversion efficiency of the thermoelectric converting module may be improved by raising the temperature at the high temperature side so as to increase the temperature difference between the high temperature side and the low temperature side. This may require improvement in heat conduction of the respective members at the high temperature and low temperature sides as well as improvement in the heat conduction between the thermoelectric converting module and the exhaust pipe/cooling unit which are respectively in contact with the thermoelectric converting module under appropriate surface pressures.

As the temperature in the high temperature side of the exhaust heat power generation apparatus can be increased up to 800°, each thermal expansion of the dimension in the longitudinal, width, and thickness directions thereof becomes large in accordance with the temperature increase. While as the temperature in the low temperature side can be increased to 100° at the highest, each thermal expansion of the dimension in the respective directions becomes small. As a result, dimensional difference between the high temperature side and the low temperature side of the thermoelectric converting module occurs, resulting in distortion. This may cause a positional displacement between the thermoelectric converting module and the exhaust pipe/cooling portion, or deformation in the thermoelectric elements. Heavy deformation in the thermoelectric elements may cause breakage in the exhaust heat power generation apparatus. As the surface contact between the thermoelectric converting module and the exhaust pipe/cooling unit is interfered by the thermal expansion, the heat conduction therebetween is deteriorated, decreasing the thermoelectric conversion efficiency. Especially an outer pipe of a generally employed exhaust heat power generation apparatus, to which the exhaust pipe and the cooling units are attached, is formed of a single member. The above-formed outer pipe is hardly allowed to absorb the aforementioned distortion. As a result, the distortion extends over the apparatus. If the cooling unit is formed of a water cooling system with high rigidity, it may further be difficult to absorb the distortion owing to low spring constant.

Conventionally the outer pipe of the exhaust heat power generation apparatus, to which the exhaust pipe and the cooling unit are attached, is formed of the material exhibiting low thermal expansion ratio such as a stainless steel so as to reduce the thermal distortion. The stainless steel exhibits low thermal conductivity, and therefore, high heat resistance. As a result, the thermal energy is lost during passage through the members at the high temperature and the low temperature sides before it is transferred to the thermoelectric converting module. This may deteriorate the thermoelectric conversion efficiency.

JP-A-11-122960 discloses an exhaust heat generating device interposing buffer elements between the thermoelectric element and the cooling unit in order to absorb mechanical oscillation of the supporting members due to temperature changes. However, by interposing additional material between the thermoelectric element and the cooling unit the thermoelectric conversion is deteriorated.

### SUMMARY OF THE INVENTION

It is an object of the invention to provide an exhaust heat generation apparatus with excellent thermoelectric conversion efficiency.

An exhaust heat power generation apparatus includes a thermoelectric converting unit that converts thermal energy of exhaust gas into electric energy; a heat exchange unit provided on one surface of the thermoelectric converting unit to conduct the thermal energy of the exhaust gas that flows through an exhaust pipe, and a cooling unit provided on the other surface of the thermoelectric converting unit to cool the thermoelectric converting unit. The cooling unit has a rigidity set to a highest value among those of the thermoelectric converting unit, the heat exchange unit and the cooling unit.

The exhaust heat power generation apparatus includes a system in which the thermoelectric converting unit is interposed between the heat exchange unit that conducts the thermal energy of the exhaust gas flowing through the exhaust pipe and the cooling unit such that the thermal energy is transferred. In the aforementioned system, the cooling unit has the highest rigidity. This makes it possible to allow the cooling unit to apply appropriate surface pressure to the thermoelectric converting unit in the system in which the thermal energy is transferred. That is, the surface contact between the cooling unit and the thermoelectric converting unit may be uniformized, resulting in improved surface contact. This may improve the thermal energy transfer to the thermoelectric converting unit, and further improve the thermoelectric conversion efficiency.

In the exhaust heat power generation apparatus, the heat exchange unit includes a heat exchange fin for conducting the thermal energy of the exhaust gas and a base having one surface on which the heat exchange unit is placed, and the other surface on which the thermoelectric converting unit is placed. The exhaust pipe includes a main body that forms a frame of an exhaust passage to which the base is attached, and the heat exchange fin provided therein. The base has a rigidity set to a highest value among those of the exhaust passage including the exhaust pipe and the heat exchange unit.

In the exhaust heat power generation apparatus, the heat exchange unit includes the heat exchange fin and the base on which the thermoelectric converting unit is placed. The exhaust pipe includes a main body that constitutes a frame of the exhaust passage. In the exhaust heat power generation apparatus, the base of the heat exchange unit is attached to the main body of the exhaust pipe so as to form the exhaust passage. The base has the highest rigidity among those of the other members of the exhaust passage. This may allow the heat exchange unit to apply appropriate surface pressure to the thermoelectric converting unit. That is, the surface contact between the heat exchange unit and the thermoelectric converting unit may be uniformized, resulting in improved surface contact. This may improve the thermal energy transfer to the thermoelectric converting unit, and further improve the thermoelectric conversion efficiency.

In the exhaust heat power generation apparatus, the main body of the exhaust pipe is formed of a material exhibiting a thermal expansion ratio lower than that of the heat exchange unit.

In the exhaust heat power generation apparatus, the main body of the exhaust pipe that is excluded from the system in which the thermal energy is transferred is formed of a material exhibiting lower thermal expansion ratio than that of the heat exchange unit, for example, stainless steel and the like. Accordingly, the main body of the exhaust pipe is unlikely to be expanded under the heat of the exhaust gas. As a result, the distortion in the exhaust heat power generation apparatus as a whole can be restrained. The system in which the thermal energy is transferred such as the heat exchange unit and the cooling unit may be formed of the material exhibiting higher thermal expansion ratio, such as aluminum as well as high thermal conductivity. This may reduce the thermal resistance in the system, thus improving the thermoelectric conversion efficiency.

In the exhaust heat power generation apparatus, the main body of the exhaust pipe is provided in a center of the exhaust heat power generation apparatus. The thermoelectric converting unit is provided on an outer periphery of the heat exchange unit attached to the main body of the exhaust pipe. The cooling unit is provided on an outer periphery of the thermoelectric converting unit. The exhaust heat power generation apparatus further includes an elastic member provided on an outer side of the cooling unit, and an elastic system for fixing the thermoelectric converting unit is formed, in which a pressure is applied to the cooling unit externally by the elastic member.

In the exhaust heat power generation apparatus, the main body of the exhaust pipe is placed in the center of the apparatus, and the thermoelectric converting unit is interposed between the heat exchange unit to which the main body of the exhaust pipe is attached and the cooling unit. This apparatus includes the elastic system in which the elastic member serves to compress the cooling unit externally so as to fix the thermoelectric converting unit between the heat exchange unit and the cooling unit. The elastic system serves to compress the thermoelectric converting unit between the heat exchange unit and the cooling unit with lower spring constant, and to further compress the thermoelectric converting unit by allowing the heat exchange unit and the cooling unit to apply appropriate surface pressures to the thermoelectric converting unit. This makes it possible to absorb the distortion between the high temperature side (heat exchange unit) and the low temperature side (cooling unit) of the thermoelectric converting module with lower spring constant.

In the exhaust heat power generation apparatus, the thermoelectric converting unit includes a module formed of a plurality of thermoelectric elements. A unit of the elastic system is structured based on the module.

In the exhaust heat power generation apparatus, the thermoelectric converting unit is mainly formed of a module having a plurality of thermoelectric elements. The single unit of the elastic system, thus is formed based on the module of the thermoelectric converting unit. Therefore, the exhaust heat power generation apparatus includes the elastic system formed of a plurality of units of the elastic systems arranged along the longitudinal and peripheral direction of the main body of the exhaust pipe. Even if the distortion occurs in the certain elastic system, such distortion may be prevented from extending over the other unit of the elastic system because each of the elastic systems is independently provided. The distortion occurred in the unit of the elastic system, thus, is not accumulated.

In the exhaust heat power generation apparatus, the elastic member includes a spring and a compression member which are one of in point contact and line contact with each other.

In the exhaust heat power generation apparatus, even if the point at which the elastic member compresses the cooling unit is displaced owing to the distortion under the heat, the surface pressure applied from the elastic member to the cooling member (from the cooling unit to the thermoelectric converting unit) may be uniformized. This is because the spring and the compression member are in point contact or line contact. This makes it possible to improve the surface contact between the cooling unit and the thermoelectric converting unit.

In the exhaust heat power generation apparatus, each of the heat exchange unit and the main body of the exhaust pipe has a variable configuration such that a direction in which the heat exchange unit deforms becomes opposite to a direction in which the main body of the exhaust pipe deforms

In the exhaust heat power generation apparatus, the direction of the distortion in the heat exchange unit is opposite to the direction of the distortion in the main body of the exhaust pipe. Two opposite distortion forces may be offset, thus restraining the distortion in the exhaust passage. Even if the heat exchange fin is distorted or expanded under the heat, the distortion of the elastic system or the exhaust heat power generation apparatus may be restrained.

### BRIEF DESCRIPTION OF THE DRAWINGS

Fig. 1 is a perspective view of an exhaust heat power generation apparatus according to an embodiment of the invention;
Fig. 2 is a front view of the exhaust heat power generation apparatus as shown in Fig. 1;
Fig. 3 is a side view of the exhaust heat power generation apparatus at an upstream side as shown in Fig. 1;
Fig. 4 is a sectional view taken along line IV-IV of the side view shown in Fig. 3;
Fig. 5 is a sectional view taken along line V-V of the side view shown in Fig. 2;
Fig. 6 is a sectional view taken along line VI-VI of the side view shown in Fig. 2;
Fig. 7A is a side view of a main body of a divided exhaust pipe as shown in Fig. 5;
Fig. 7B is a plan view showing a part of the divided exhaust pipe in the longitudinal direction;
Fig. 8A is a plan view of a lid of the cooling unit shown in Fig. 5;
Fig. 8B is a sectional view taken along line VIIIB-VIIIB of the plan view shown in Fig. 8A;
Fig. 9A is a plan view of a main body of the cooling unit shown in Fig. 5;
Fig. 9B is a sectional view taken along line IXB-IXB of the plan view shown in Fig. 9A;
Fig. 9C is a sectional view taken along line IXC-IXC of the plan view shown in Fig. 9A;
Fig. 10A is a front view of a heat exchange member shown in Fig. 5;
Fig. 10B is a side view of the heat exchange member shown in Fig. 5;
Fig. 10C is a bottom view of the heat exchange member shown in Fig. 5;
Fig. 11A is a plan view of a clamp shown in Fig. 5;
Fig. 11B is a front view of the clamp shown in Fig. 5;
Fig. 12 is a plan view of a leaf spring shown in Fig. 5;
Fig. 13A is a plan view of a compression member shown in Fig. 5;
Fig. 13B is a sectional view taken along line XIIIB-XIIIB of the plan view shown in Fig. 13A; and
Fig. 14 is a perspective view representing the exhaust heat power generation apparatus placed in the vicinity of an exhaust manifold.

### DETAILED DESCRIPTION OF THE EMBODIMENTS

An exhaust heat power generation apparatus will be described referring to the drawings.

In this embodiment, an exhaust heat power generation apparatus according to the invention is mounted on a vehicle such that the thermal energy of the exhaust gas discharged from the gasoline engine is converted into electric energy. The exhaust heat power generation apparatus has an exhaust pipe of tetrameric type (divided into 4 parts along the periphery). There are 4 exhaust heat power generation units arranged along the periphery, and 4 exhaust heat power generation units arranged in the longitudinal direction. Accordingly the exhaust heat power generation apparatus includes 16 exhaust heat power generation units in total.

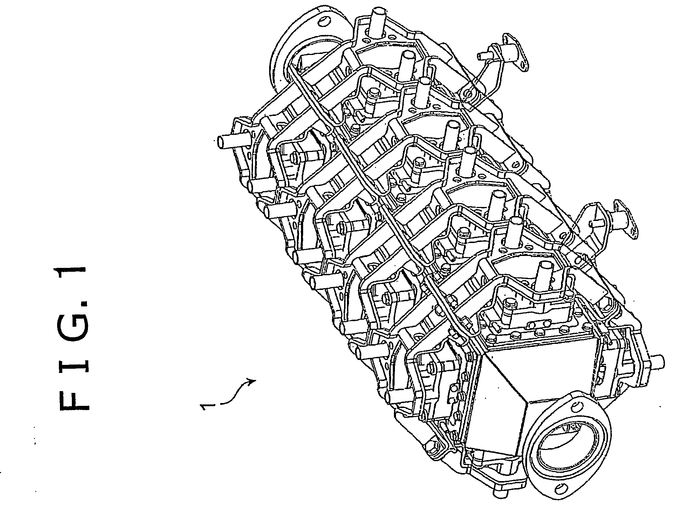

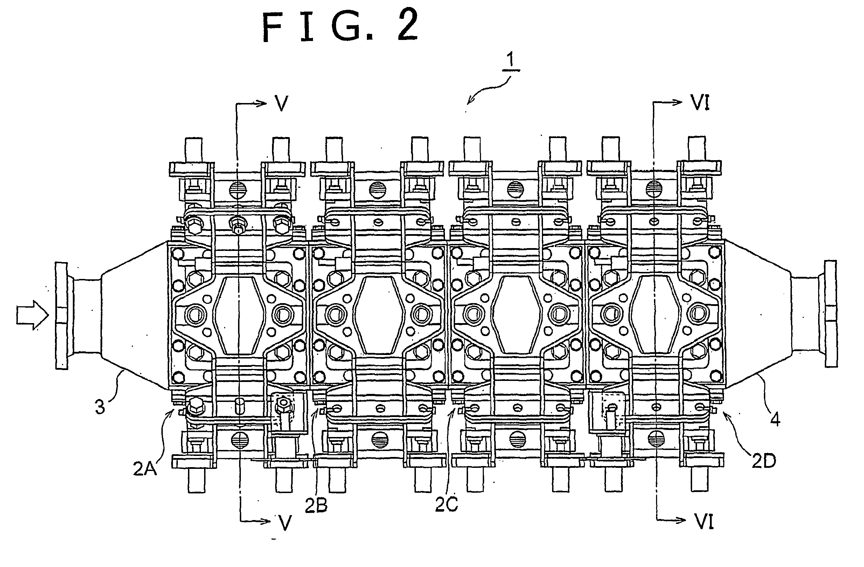

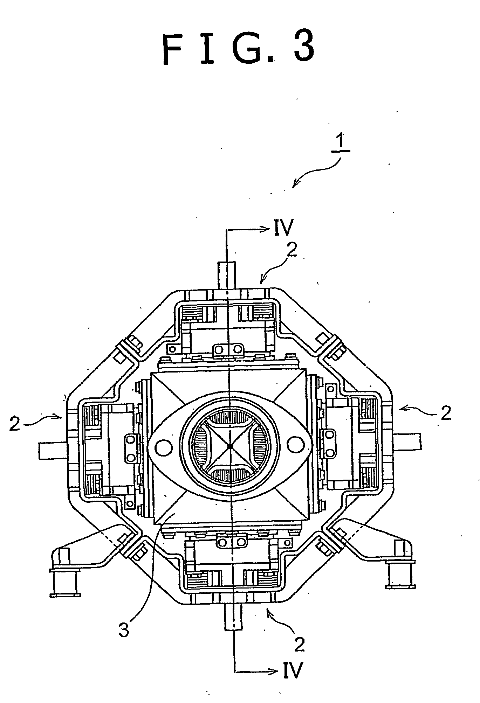

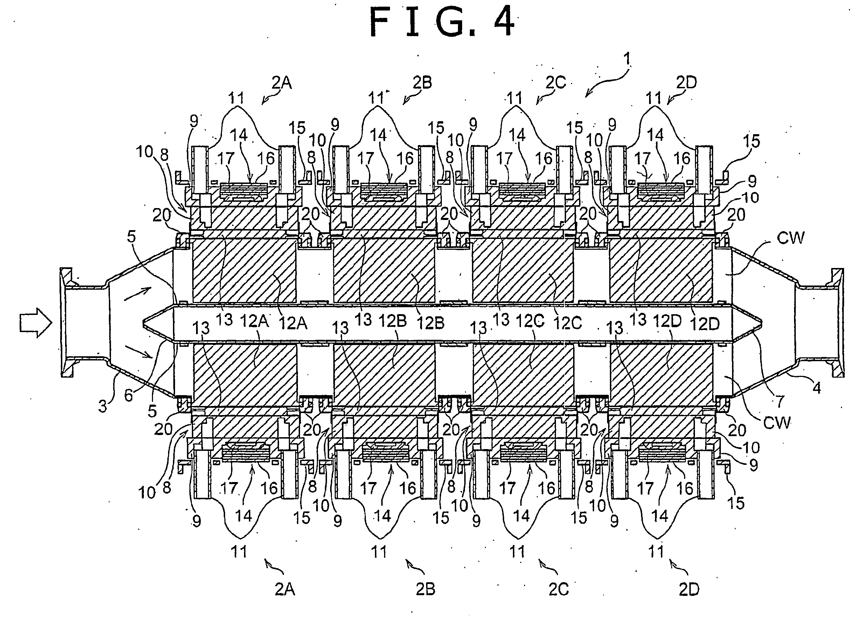

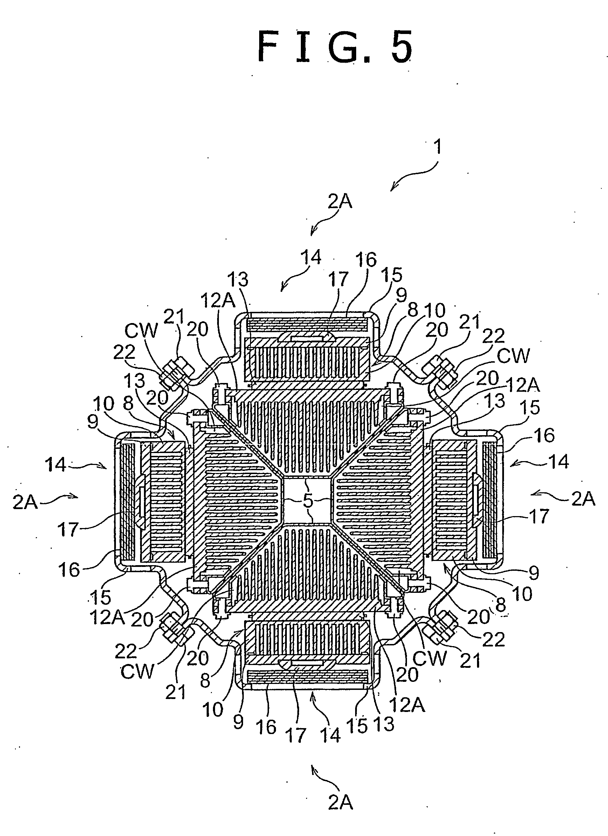

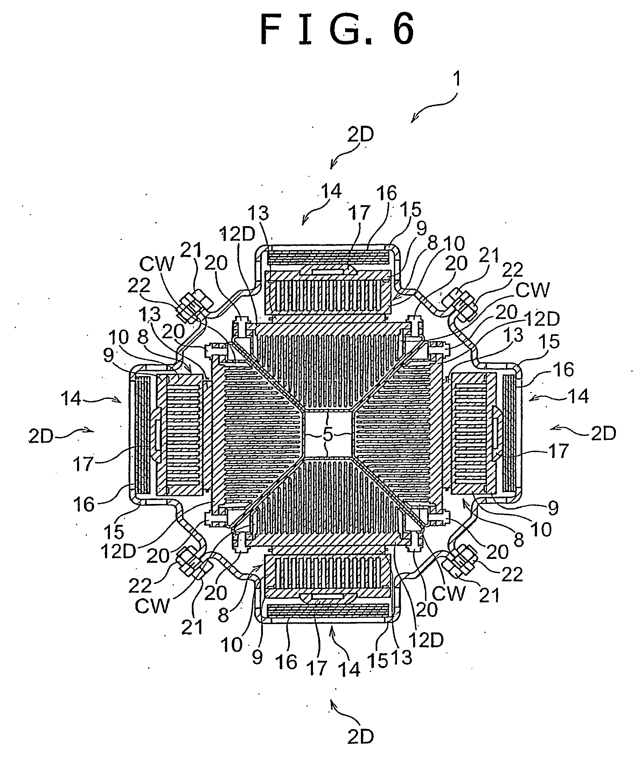

Referring to Figs. 1 to 6, the structure of an exhaust heat power generation apparatus 1 will be described. Fig. 1 is a perspective view of the exhaust heat power generation apparatus. Fig. 2 is a front view of the exhaust heat power generation apparatus of Fig. 1. Fig. 3 is a side view of the exhaust heat power generation apparatus at an upstream side. Fig. 4 is a sectional view taken along line IV-IV of the side view shown in Fig. 3. Fig. 5 is a sectional view taken along line V-V of the front view shown in Fig. 2. Fig. 6 is a sectional view taken along line VI-VI of the front view shown in Fig. 2.

The exhaust heat power generation apparatus 1 is provided at an arbitrary position of an exhaust system connected to an exhaust manifold of a gasoline engine (not shown). For example, the exhaust heat power generation apparatus may be provided in the vicinity of the exhaust manifold, at an upstream side of an exhaust purification catalyst, at an upstream side of a muffler and the like. The exhaust heat power generation apparatus 1 is of tetrameric type along the periphery of the exhaust pipe and includes 16 exhaust heat power generation units 2. The exhaust heat power generation apparatus 1 includes 4 exhaust heat power generation units 2 along the peripheral direction (see Fig.3), and 4 exhaust heat power generation units 2A to 2D along the longitudinal direction (see Fig. 2). In the exhaust heat power generation apparatus 1, each of the exhaust heat power generation units 2 serves to convert the thermal energy of the exhaust gas into electric energy which is charged into a battery (not shown) via a DC/DC converter (not shown).

In the exhaust heat power generation apparatus 1, an exhaust introduction pipe 3 connected to an exhaust pipe (not shown) at upstream side is provided at an end of the upstream side, and an exhaust discharge pipe 4 connected to an exhaust pipe (not shown) at downstream side is provided at an end of the downstream side. There are 4 divided exhaust pipes 5 which are connected with one another through welding between the exhaust introduction pipe 3 and the exhaust discharge pipe 4. Each of those divided exhaust pipes 5 is arranged at every 90° at the center of the exhaust heat power generation apparatus 1 (see Fig. 5), forming each frame of 4 divided exhaust passages CW, respectively. In this embodiment, each of the divided exhaust pipe 5 corresponds to the main body of the exhaust pipe.

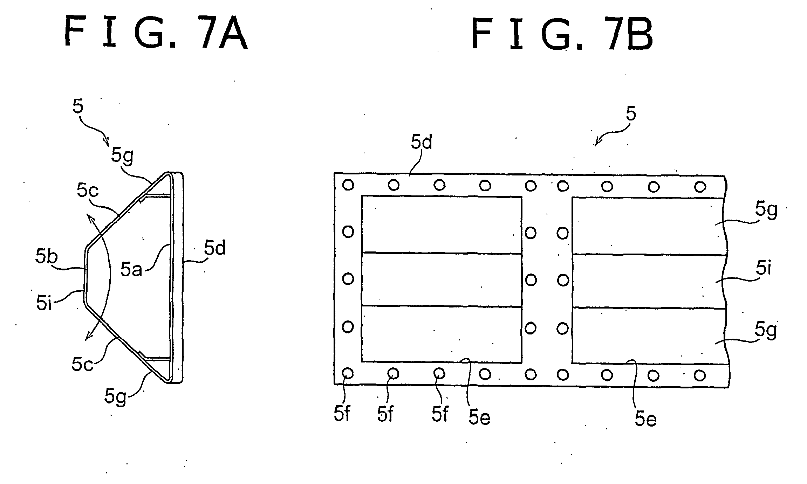

Referring to Figs. 7A and 7B, the divided exhaust pipe 5 will be described. Fig. 7A is a side view of the divided exhaust pipe 5, and Fig. 7B is a plan view representing a portion of the divided exhaust pipe 5 in the longitudinal direction.

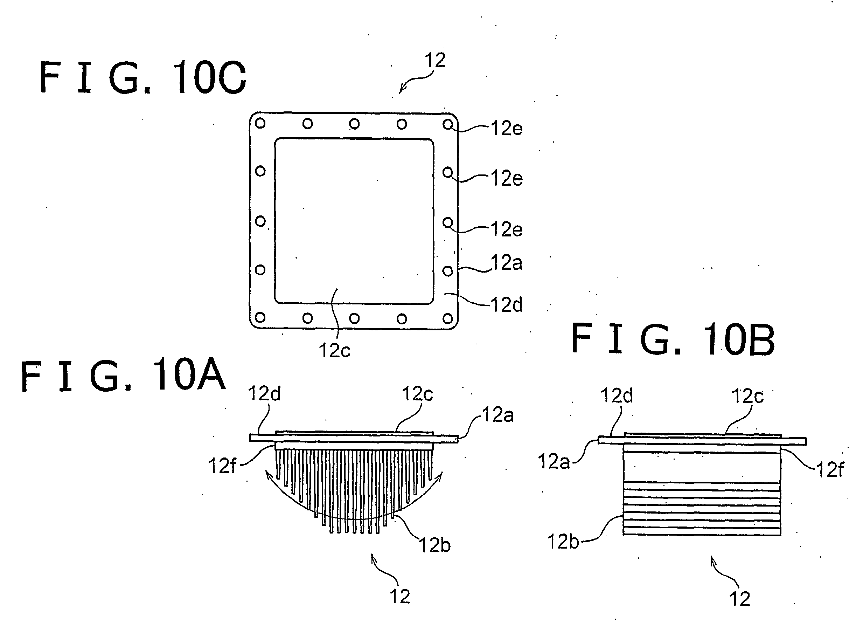

The divided exhaust pipe 5 is formed of a stainless steel having a main portion of a thin plate-like shape. Referring to Fig. 7A, the divided exhaust pipe 5 has an isosceles trapezoidal shape as a side view. Each angle defined by the long side 5a and two sides 5c each connecting between the respective ends of the long side 5a and the short side 5b is 45°. An outer plate 5d corresponding to the long side 5a of the divided exhaust pipe 5 is provided with 4 openings 5e arranged in the longitudinal direction. In Fig. 7A, 2 openings 5e are only shown. The opening 5e has a substantially square shape, to which a heat exchange fin 12b of a heat exchange member 12 is inserted as shown in Fig. 10. The outer plate 5d has bolt holes 5f formed therein through which the heat exchange member 12 is tightened with a bolt along the outer periphery of the opening 5e. The thickness of the outer plate 5d is larger than that of the other portions of the divided exhaust pipe 5. The bolt hole 5f is provided with a female thread.

Side plates 5g of each of the divided exhaust pipes 5 are welded to the respective side plates 5g of adjacent divided exhaust pipes each arranged at 90°. Then 4 divided exhaust pipes 5 are connected along the periphery and formed into a substantially square shape as the side view (see Fig. 5). Each of the divided exhaust pipes 5 is provided with 4 heat exchange members 12. A divided exhaust passage CW is formed by closing 4 openings 5e. Both ends of each of inner plates 5i of 4 divided exhaust pipes 5 are connected to a split member 6 at an upstream side through welding, and a joint member 7 at a downstream side through welding (see Fig. 4). The split member 6 is formed like a quadrangular pyramid shape having its width reduced as it goes upstream such that the flow of the exhaust gas from the exhaust introduction pipe 3 is split into 4 divided exhaust passages CW. The joint member 7 is formed like a quadrangular pyramid shape having its width reduced as it goes downstream such that the exhaust gas each flowing through 4 divided exhaust passages CW is joined together.

Each of the divided exhaust pipes 5 is formed of the stainless steel exhibiting lower thermal expansion ratio than that of aluminum, having relatively lower degree of thermal expansion compared with the other members that constitute the exhaust heat power generation apparatus 1. As the divided exhaust pipe 5 is formed into the thin plate-like isosceles trapezoidal shape, it has lower rigidity compared with the other members for the exhaust heat power generation apparatus 1 (especially heat exchange member 12). Therefore, the divided exhaust pipe 5 is deformed in the direction where the side plates 5g deform toward the short walls 5i as shown by arrow of Fig. 7A. As the rigidity of the divided exhaust pipe 5 is lower than that of the cooling unit 8, it may be deformed followed by the shape of the heat exchange surface of the cooling unit 8.

The exhaust heat power generation unit 2 is mainly formed of a thermoelectric converting module 13. Various elements that constitute the unit 2 are formed based on the size of the thermoelectric converting module 13. In the exhaust heat power generation unit 2, appropriate pressure (for example, 14 kg/cm²) is applied to the thermoelectric converting module 13 from the low temperature side and the high temperature side. The exhaust heat power generation unit 2 is flexibly compressed by the spring system so as to improve the thermoelectric conversion efficiency of the thermoelectric converting module 13. Then each of the exhaust heat power generation units 2 is fit in the opening 5e of the divided exhaust pipe 5, respectively. In the exhaust heat power generation apparatus 1, 4 exhaust heat power generation units 2A, 2B, 2C, 2D are arranged between the upstream side and the downstream side such that the thermoelectric conversion efficiency can be uniformly obtained at either the upstream or the downstream side. The exhaust heat power generation unit 2 is provided with a cooling unit 8, the heat exchange member 12 (12A, 12B, 12C, 12D), the thermoelectric converting module 13, and a spring clamp 14, forming the system through which the thermal energy is transferred and the spring clamp system. In this embodiment, the exhaust heat power generation unit 2 may correspond to the elastic system, and the heat exchange member 12 may correspond to the heat exchange unit. The thermoelectric converting module 13 may correspond to the thermoelectric converting unit, and the spring clamp 14 may correspond to the elastic member. The divided exhaust pipes 5 and the heat exchange members 12 may constitute the exhaust passage system.

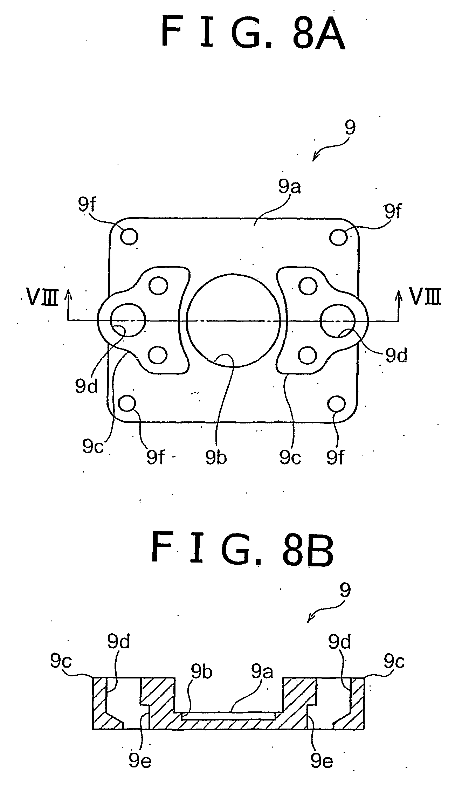

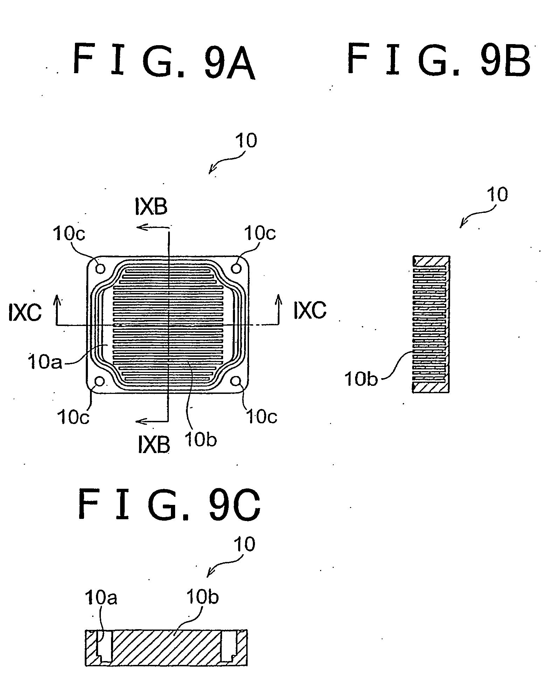

The cooling unit 8 will be described referring to Figs. 8A to 9C. Fig. 8A is a plan view of a lid of the cooling unit 8, and Fig. 8B is a sectional view taking along VIIIB-VIIIB of the plan view shown in Fig. 8A. Fig. 9A is a plan view of a main body of the cooling unit 8, Fig. 9B is a sectional view taken along IXB-IXB of the plan view shown in Fig. 9A, and Fig. 9C is a sectional view taken along IXC-IXC of the plan view shown in Fig. 9A.

The cooling unit 8 serves to apply appropriate pressure to a low temperature end surface of the thermoelectric converting module 13 so as to be fixed and cooled with water. The cooling unit 8 has the highest rigidity among elements of the exhaust heat power generation unit 2 (especially in the system where the thermal energy is transferred). The cooling unit 8 serves as a reference based on which the thermoelectric converting module 13 is fixed by the exhaust heat power generation unit 2 (especially the spring clamp system). The cooling unit 8 is provided with a cooling lid 9, a main body 10, and cooling water pipes 11.

The lid 9 for the main body 10 of the cooling unit 8 is formed of aluminum. The dimension of the lid 9 in the width direction is the same as that of the main body 10. The lid 9 includes a thick plate portion 9a having the dimension in the longitudinal direction slightly larger than that of the main body 10. A circular bottomed hole 9b is formed in the center of the plate portion 9a so as to receive a compression member 17 to be fit therein. Two support portions 9c are provided around the hole 9b, each of which serves to support leaf springs 16 from both sides and to place cooling water pipes 11. The support portions 9c are placed on the positions such that the distance therebetween becomes slightly longer than the dimension of the leaf spring in the longitudinal direction. The support portions 9c are further arranged such that their upper surfaces become slightly lower than each upper surface of the leaf springs 16. The configuration of the support portion 9c closer to the hole 9d is formed along the end shape of the leaf spring 16. Fitting holes 9d are formed in the outer end side of the respective support portions 9c such that the respective cooling water pipes 11 are fit therein. Cooling water holes 9e are further formed in the support portions 9c, each communicated with lower side portion of the fitting holes 9d, respectively. The cooling water holes 9e pierce through the bottom of the lid 9 so as to be communicated with a cooling portion 10a of the main body 10. Four holes 9f are formed at each corner of the plate portion 9a through which the main body 10 is tightened with bolts.

Referring to Figs. 9A to 9C, the main body 10 is formed as a box to be closed with the lid 9, which is made of aluminum. The main body 10 has a box-like shape with large thickness and dimension slightly longer than that of the thermoelectric converting module 13 both in the width and longitudinal directions. A recess portion of the main body 10 constitutes a cooling portion 10a into which the cooling water flows. The cooling portion 10a is provided with a cooling fin 10b for cooling the cooling water. Each fin of the cooling fin 10b has the same height so as to be in contact with the bottom of the lid 9 when being set onto the main body 10. The bottom surface of the main body 10 is flat so as to be in tight contact with the low temperature end surface of the thermoelectric converting module 13. Four bottomed bolt holes 10c are formed in each corner of the main body 10 through which the lid 9 is tightened with the bolts. Each of the bolt holes 10c is provided with a female thread.

The lid 9 is set to be fixed on the main body 10 by tightening 4 bolts (not shown), and 2 cooling water pipes 11 are attached to the lid 9 by welding to form the cooling unit 8. As the cooling unit 8 is structured based on the size of the thermoelectric converting module 13, the area of the cooling unit 8 may be kept reduced. As the cooling unit 8 has a box-like shape with large thickness, its rigidity is the highest among those of the elements of the exhaust heat power generation unit 2. The thermoelectric converting module 13 may be fixed based on the rigidity of the cooling unit 8. As a result, the contact between the cooling unit 8 and the low temperature end surface of the thermoelectric converting module 13 is uniformized, improving thermal contact therebetween. Therefore, the heat exchange between the cooling unit 8 and the thermoelectric converting module 13 may further be enhanced.

The exhaust heat power generation apparatus 1 has 4 cooling units 8 arranged in the longitudinal direction as shown in Fig. 4. The cooling water pipe 11 upstream of the cooling unit 8 at the most upstream side and the cooling water pipe 11 downstream of the cooling unit 8 at the most downstream side are connected to a radiator (not shown) via a radiator hose (not shown). The other cooling water pipes 11 are connected with each other between adjacent cooling units 8. In each of the cooling unit 8, cooling water that has been cooled with the radiator is introduced into the cooling portion 10a through the cooling water pipe 11 and the cooling water hole 9e. The cooling water then flows through fins of the cooling fin 10b so as to be cooled. This may keep the cooling water at lower temperature. As the cooling unit 8 is formed of aluminum exhibiting substantially lower thermal conductivity than that of the stainless steel, the resultant thermal resistance may be reduced. Accordingly the cooling unit 8 is capable of transferring heat to the thermoelectric converting module 13 while keeping the lower temperature.

Referring to Figs. 10A to 10C, the heat exchange member 12 will be described. Figs. 10A, 10B, and 10C are a front view, a side view and a bottom view of the heat exchange member 12, respectively.

The heat exchange member 12 made of aluminum is mainly formed of a base 12a and a heat exchange fin 12b. The base 12a has a thick plate-like shape, and a table portion 12c with a thickness slightly larger than that of the outer peripheral portion in the center thereof, on which the thermoelectric converting module 13 is provided. The table portion 12c has a dimension slightly longer than that of the thermoelectric converting module 13 both in the width and longitudinal directions. The upper surface of the table portion 12c has a flat face so as to be brought into tight contact with the high temperature end surface of the thermoelectric converting module 13. The outer peripheral portion of the base 12a forms a flange portion 12d that is engaged with an outer plate 5d of the divided exhaust pipe 5 to which the heat exchange member 12 is attached. A plurality of holes 12e are formed in the flange portion 12d, through which the divided exhaust pipe 5 is fixed and tightened with bolts. The surface of the base 12a that faces the heat exchange fin 12b has a fin base 12f attached thereto. The fin base 12f has a size so as to be fit with the opening 5e of the divided exhaust pipe 5. The heat exchange fin 12b attached to the fin base 12f has a height such that each fin of the heat exchange fin 12b becomes close to the side plates 5g and the inner plate 5i but not in contact thererwith when the heat exchange member 12 is attached to the divided exhaust pipe 5. Therefore all the fins of the heat exchange fin 12b form substantially isosceles trapezoidal shape as shown in Fig. 10A. The exhaust heat power generation apparatus 1 includes 4 heat exchange members 12A to 12D arranged in the longitudinal direction (see Fig. 4). The pitch between fins of the heat exchange fin 12b of the heat exchange member 12 is set so as to become smaller as it goes downstream (see Figs. 5 and 6). The closer to the upstream the heat exchange member 12 becomes, the more the number of fins of the heat exchange fin 12b becomes.

Each of the heat exchange members 12A to 12D is fit with the opening 5e formed in the divided exhaust pipe 5 so as to be tightened with the bolt 20. As a result, divided exhaust passages CW are formed as shown in Figs. 4 to 6. As the base 12a of the heat exchange member 12 is structured based on the size of the thermoelectric converting module 13, its area may be kept reduced. The base 12a further has a thick plate-like shape, resulting in the highest rigidity among those of the divided exhaust pipe 5 and the heat exchange member 12 that constitute the divided exhaust passage CW. Accordingly the contact between the base 12a and the high temperature end surface of the thermoelectric converting module 13 is uniformized, thus improving thermal contact therebetween. This makes it possible to improve heat transfer between the heat exchange member 12 and the thermoelectric converting module 13.

The surface area of the heat exchange fin 12b is varied by changing the pitch between fins of the heat exchange fin 12b in accordance with the position in the longitudinal direction of the exhaust heat power generation apparatus 1 so as to cope with the decrease in the exhaust gas temperature (reduced thermal energy) as it flows toward the downstream side. The surface area of the heat exchange fin 12b is increased by decreasing the pitch between fins as it becomes closer to the downstream. This may allow the area in contact with the exhaust gas to be increased, increasing the amount of the thermal energy of the exhaust gas. The aforementioned structure makes it possible to equalize the absorbed thermal energy obtained in the respective heat exchange members 12A to 12D arranged in the longitudinal direction of the exhaust heat power generation apparatus 1, and to uniformize the temperature at the surface of contact between each of the heat exchange members 12A to 12D and the corresponding thermoelectric converting modules 13, for example, at 400°C.

The base 12a of the heat exchange member 12 has a large thickness and a high rigidity. The height of each fin of the heat exchange fin 12b is set such that the heat exchange fin 12b is formed into substantially isosceles trapezoidal shape. As a result, the heat exchange member 12 deforms in the direction such that each fin of the heat exchange fin 12b expands toward the base 12a as shown in Fig. 10A.

The thermoelectric converting module 13 includes a plurality of thermoelectric elements (not shown), for example, semiconductors of p type and n type formed of Bi₂Te₃ which are arranged in series electrically and in parallel thermally. The thermoelectric converting module 13 has a substantially square shape with small area, having a high temperature end surface and a low temperature end surface horizontally arranged in parallel with each other. The thermoelectric converting module 13 serves to convert the thermal energy into the electric energy using the temperature difference between both end surfaces based on Seebeck effect such that electric energy is output from two electrodes (not shown).

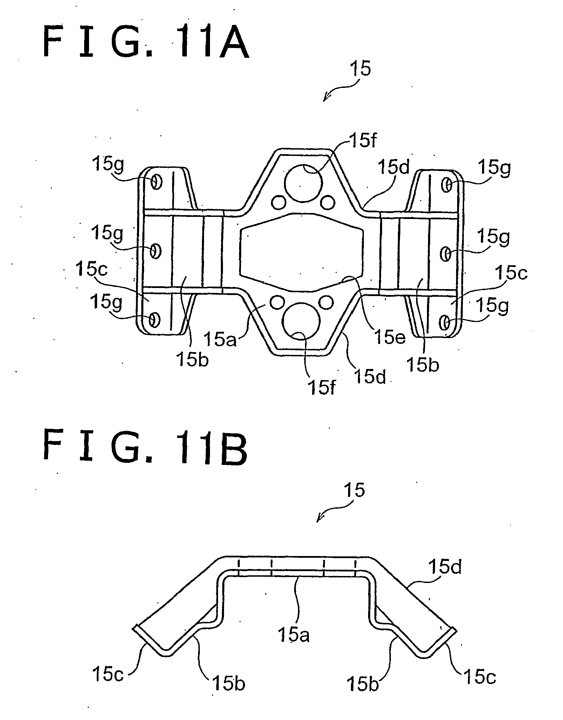

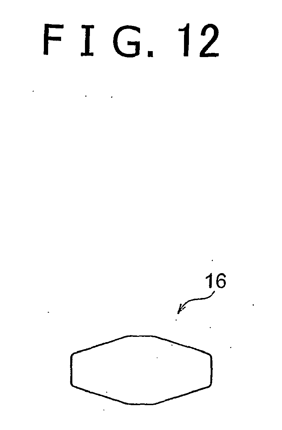

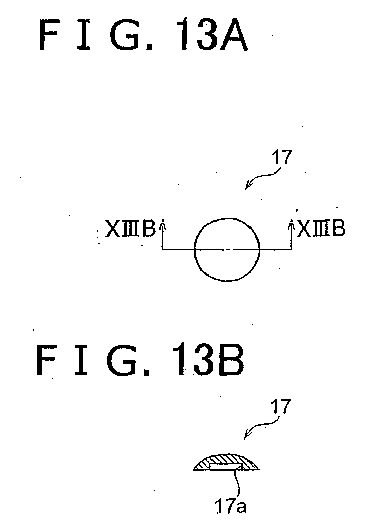

Referring to Figs. 11A to 13B, the spring clamp 14 will be described. Figs. 11A and 11B shows a plan view and a front view of a clamp portion. Fig. 12 is a plan view of the leaf spring. Fig. 13A is a plan view of the compression member, and Fig. 13B is a sectional view taken along line XIIIB-XIIIB of the plan view shown in Fig. 13A.

The spring clamp 14 serves to apply a predetermined pressure to the thermoelectric converting module 13 from the outside of the cooling unit 8 so as to be fixed between the cooling unit 8 and the heat exchange member 12. At this time, the spring clamp 14 flexibly compresses the exhaust heat power generation unit 2 as a whole with the elastic force derived from a plurality of leaf springs. Four spring clamps 14 are fastened to the exhaust heat power generation apparatus 1 along its periphery so as to be tightened. The spring clamp 14, therefore, includes a clamp 15, a plurality of leaf springs 16, and the compression member 17. The predetermined pressure applied to the thermoelectric converting module 13 is set such that each surface pressure applied between the thermoelectric converting module 13 and the cooling unit 8 and between the thermoelectric converting module 13 and the heat exchange member 12 becomes an appropriate value.

Referring to Figs. 11A and 11B, the clamp 15 formed of iron includes a storage portion 15a, connecting portions 15b, fastening portions 15c and side plate portions 15d. The storage portion 15a, connecting portions 15b and the fastening portions 15c are all formed from a single plate, both ends of which are provided with side plates 15d thereon. The storage portion 15a has a recess portion when viewed in front and a substantially ellipsoidal shape as a plan view. An opening 15e that has the same shape but slightly smaller size than those of the leaf springs 16 is formed on the storage portion 15a. The outer periphery of the opening 15e serves to compress the leaf spring 16. Holes 15f are formed at opposite ends of the storage portion 15a, with which the cooling water pipes 11 of the cooling unit 8 are fit. The connecting portions 15b serve to connect the storage portion 15a to the fastening portions 15c at both ends. The fastening portion 15c is formed by bending both ends of the plate that constitutes the clamp 15 at right angles with respect to the connecting portions 15b so as to be in contact with the adjacent bottom surface of the clamp 15. Three bolt holes 15g through which bolts pierce are formed in each of the fastening portions 15c. When 4 clamps 15 are connected and fastened, they form a substantially circular shape as a sectional view, covering the outermost portion of the exhaust heat power generation apparatus 1 (see Figs. 5 and 6).

Referring to Fig. 12, the leaf spring 16 has a substantially ellipsoidal shape as a plan view, which is formed of iron. As the leaf spring 16 has a small spring constant, the spring clamp 14 generates the elastic force by stacking a plurality of the leaf springs 16.

The compression member 17 is formed of iron and has a semi-spherical shape so as to be in point contact with the leaf spring 16. The circular bottom surface of the compression member 17 has a size sufficient to be fit with the hole 9b formed in the cooling unit 8 as shown in Figs. 8A and 8B. A bottomed hole 17a is formed in the center of the bottom surface of the compression member 17.

In the spring clamp 14, the compression member 17 is fit with the hole 9b of the lid 9 of the cooling unit 8. A plurality of the leaf springs 16 are stacked on the compression member 17. The clamp 15 is placed on the leaf springs 16 so as to cover a part of the leaf springs 16 and the cooling unit 8 with the storage portion 15a. The leaf springs 16 are supported by the support portions 9c of the lid 9 at both sides. The top surface of the stacked leaf springs 16 is higher than the support portions 9c. The fastening portions 15c of the clamp 15 are aligned with respect to the fastening portions 15c of the clamps 15 at both sides such that fastening portions 15c of the adjacent clamps 15 are fastened with bolts 21 and nuts 22 as shown in Figs. 5 and 6. The exhaust heat power generation apparatus 1 is fastened with 4 spring clamps 14 that are fastened along the periphery and functioning like a belt.

In the spring clamp 14, a predetermined pressure is applied to the cooling unit 8 (to the thermoelectric converting module 13 and heat exchange member 12) from the compression member 17 under pressure applied by the clamp 15 through the leaf springs 16 and the compression member 17. The predetermined pressure is adjustable by changing the fastening force of the bolts 21 and nuts 22. Even if deviation occurs in the compression owing to positional displacement of the leaf springs 16 or the clamp 15, the uniform pressure is applied to the cooling unit 8 from the compression member 17 that is in point contact with the leaf springs 16. As a result, uniform surface pressure is generated on the cooling unit 8. As the elastic force is generated by stacking a plurality of the leaf springs 16 each having a small spring constant, the thermoelectric converting module 13 may be flexibly compressed.

In the exhaust heat power generation unit 2, the heat exchange member 12, the thermoelectric converting module 13, the cooling unit 8, and the spring clamp 14 are arranged from the center of the exhaust heat power generation apparatus 1 in the width direction. The thermoelectric converting module 13 is flexibly fixed under the appropriate surface pressure by the spring clamp 14 based on the cooling unit 8. In the exhaust heat power generation apparatus 1, 4 divided exhaust pipes 5 are arranged in the peripheral direction and 4 exhaust heat power generation units 2 are arranged in the longitudinal direction. Each of the exhaust heat power generation units 2 is independently provided in the exhaust heat power generation apparatus.

Operations of the exhaust heat power generation apparatus 1 will be described referring to Figs. 1 to 6.

The exhaust heat power generation apparatus 1 receives the flow of exhaust gas from the exhaust pipe 3 and allows the cooling water supplied through the most upstream cooling water pipe 11 to flow therethrough. The flow of the introduced exhaust gas is split into 4 by the split member so as to be lead to the respective divided exhaust passages CW.

The exhaust gas in each of the respective divided exhaust passages CW flows through fins of the respective heat exchange fins 12b of 4 heat exchange members 12A to 12D (see Fig. 10) toward downstream. The thermal energy is absorbed from the exhaust gas by the heat exchange fin 12b. The closer the exhaust gas flows downstream, the more the thermal energy is lost the exhaust gas, decreasing the exhaust gas temperature. So the pitch among those fins of the heat exchange fin 12 is reduced to improve the efficiency for absorbing the thermal energy of the exhaust gas. The heat exchange member 12 transfers the absorbed thermal energy to the table portion 12c (see Fig. 10). As the heat exchange member 12 is formed of aluminum with low thermal resistance, the temperature may be kept high until the thermal energy is transferred to the table portion 12c. The heat exchange member 12 transfers the thermal energy to the high temperature end surface of the thermoelectric converting module 13. At this time, an appropriate surface pressure is applied to the upper surface of the table portion 12c from the high temperature end surface of the thermoelectric converting module 13. The upper surface of the table portion 12c is kept flat and in contact with the high temperature end surface of the thermoelectric converting module 13 uniformly. Each of the heat exchange members 12A to 12D transfers substantially the same amount of thermal energy irrespective of their positions located at either upstream or downstream. Therefore, the high temperature end surface of the thermoelectric converting module 13 may be kept at substantially constant temperature. Each of the exhaust gas flowing through 4 divided exhaust passages CW joins at the joint member 7 so as to be discharged into the exhaust pipe downstream of the exhaust heat power generation apparatus 1. At this moment, the thermal heat is drawn from the exhaust gas, resulting in the temperature decrease.

The cooling water flows toward downstream through fins of each of the cooling fin 10b within the cooling portion 10a of 4 cooling units 8, respectively as shown in Fig. 9. The cooling water is further cooled in the cooling fin 10b. The cooling unit 8 serves to transfer the cooling water to the bottom of the main body 10 while keeping the cooling water at low temperature. The cooling unit 8 formed of aluminum with low thermal resistance functions in keeping the low temperature of the cooling water until it reaches the bottom surface. The cooling unit 8 serves to transfer the low temperature of the cooling water to the low temperature end surface of the thermoelectric converting module 13. At this moment, an appropriate surface pressure is applied to the low temperature end surface of the thermoelectric converting module 13 from the bottom surface of the main body 10. The bottom surface of the main body 10 keeps its flatness so as to be in uniform contact with the low temperature surface of the thermoelectric converting module 13. The cooling water flowing from the cooling unit 8 at the most downstream side is then discharged from the exhaust heat power generation apparatus 1.

Each of the thermoelectric converting modules 13 generates electric power using the temperature difference between the high temperature of the cooling water transferred to the high temperature end surface and the low temperature of the cooling water transferred to the low temperature end surface. The resultant electric energy is charged in the battery. As both of the high and low temperatures of the cooling water may be sufficiently held, the resultant temperature difference therebetween is substantially large. Therefore, a large amount of electric power is generated owing to high thermoelectric conversion efficiency. As the temperature at the high temperature side is held at the constant value irrespective of the position at either upstream side or the downstream side, the thermoelectric conversion efficiency is not lowered even at the downstream side.

Even if distortion occurs in any of the exhaust heat power generation units 2 under the influence of heat, the exhaust heat power generation apparatus 1 is not influenced by the distortion because each of the exhaust heat power generation units 2 is independently arranged. That is, the distortion that occurs in each of the exhaust heat power generation units 2 is not accumulated. As 4 divided exhaust pipes 5 constituting the frame of the exhaust heat power generation apparatus 1 are formed of stainless steel exhibiting low thermal expansion ratio, the degree of expansion of the apparatus by itself under the heat is small. The resultant deformation, thus, may be reduced. The exhaust heat power generation apparatus 1 is structured such that the direction in which the divided exhaust pipe 5 deforms becomes opposite to the direction in which the respective heat exchange members 12 deform. Therefore, even if both the divided exhaust pipe 5 and the heat exchange member 12 are deformed under the heat of the exhaust gas at high temperature, each deformation occurred therein may offset with each other, thus restraining the deformation in the exhaust heat power generation unit 2.

Each of the exhaust heat power generation units 2 is flexibly compressed by the elastic force of a plurality of the leaf springs 16. The aforementioned structure makes it possible to absorb the distortion occurred in the exhaust heat power generation unit 2 under the heat. As the compression member 17 is in point contact with the leaf spring 16, the surface pressure can be uniformly applied to the cooling unit 8, the thermoelectric converting module 13, and the heat exchange member 12, respectively irrespective of the positional displacement among members constituting the exhaust heat power generation unit 2.

In the exhaust heat power generation apparatus 1, the rigidity of the cooling unit 8 is set to the highest value, based on which the exhaust heat power generation unit 2 is formed. This may allow appropriate surface pressure to be applied to the thermoelectric converting module 13, thus improving the surface contact between the cooling unit 8 and the low temperature end surface of the thermoelectric module 13, and further decreasing the temperature of the low temperature end surface thereof. The rigidity of the base 12a of the heat exchange member 12 is set to the highest value at the high temperature side. This may allow appropriate surface pressure to be applied to the thermoelectric converting module 13, thus improving the surface contact between the base 12a and the high temperature end surface of the thermoelectric converting module 13, and further increasing the temperature of the high temperature end surface thereof. In the exhaust heat power generation apparatus 1, the system through which the thermal energy of the exhaust heat power generation unit 2 is transferred is formed of aluminum exhibiting high thermal conductivity. Accordingly the thermal resistance of each of the members is reduced, thus increasing the temperature at the high temperature side, and decreasing the temperature at the low temperature side of the thermoelectric converting module 13. The thermoelectric conversion efficiency of each of the exhaust heat power generation units 2 of the exhaust heat power generation apparatus 1 has a considerably high thermal converting efficiency.

In the exhaust heat power generation apparatus 1, the thermoelectric converting module 13 is flexibly fixed with the outer pressure applied by a plurality of the leaf springs 16. Even if the distortion occurs in the members constituting the apparatus 1 under the heat, the deformation (damage to the thermoelectric elements) owing to such distortion may be restrained, thus generating appropriate surface pressure. As 4 spring clamps 14 are arranged in the peripheral direction so as to tighten the apparatus 1 like a belt. The apparatus 1, thus, can be sufficiently fixed with flexibility. The compression member 17 in point contact with each of the spring clamps 14 is allowed to apply uniform surface pressure to the exhaust heat power generating apparatus constantly.

Each of the divided exhaust pipes 5 constituting the frame of the exhaust heat power generation apparatus 1 is formed of a stainless steel exhibiting a low thermal expansion ratio. This may restrain the thermal deformation of the exhaust heat power generation apparatus 1. The exhaust heat power generation unit 2 having small area is formed based on the size of the thermoelectric converting module 13 so as to be combined with the divided exhaust pipe 5. The distortion of the exhaust heat power generation unit 2 under the heat may be restrained. The influence of such distortion hardly extends over the other exhaust heat power generation unit 2. In the exhaust heat power generation apparatus 1, the direction in which the divided exhaust pipe 5 deforms is opposite to the direction in which the heat exchange member 12 deforms. Even if both the divided exhaust pipe 5 and the heat exchange member 12 are deformed under the heat, each deformation can be offset with each other, thus restraining the deformation in the exhaust heat power generation unit 2.

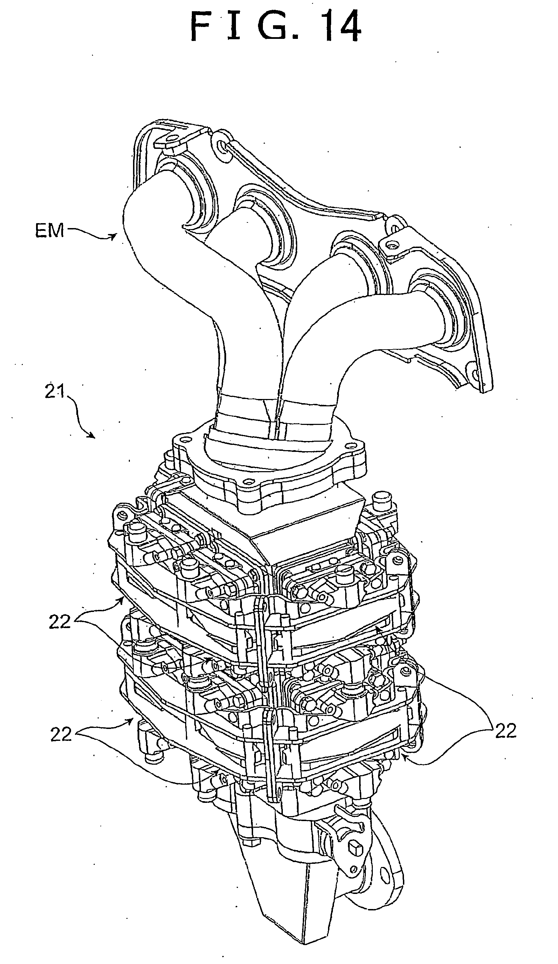

An example of the invention where an exhaust heat power generation apparatus 21 is provided in the exhaust system will be described referring to Fig. 14. Fig. 14 is a perspective view representing the exhaust heat power generation apparatus arranged in the vicinity of an exhaust manifold.

The exhaust heat power generation apparatus 21 is arranged in the vicinity of the exhaust manifold EM, a discharge port of which is directly connected to the exhaust heat power generation apparatus 21. In the exhaust heat power generation apparatus 21, the exhaust pipe is divided into 6 sections. The exhaust heat power generation apparatus 21 includes 12 exhaust heat power generation units 22. There are 6 exhaust heat power generation units 22 arranged in the peripheral direction, and 2 exhaust heat power generation units 22 arranged in the longitudinal direction. As the exhaust heat power generation apparatus 21 is arranged in the vicinity of the exhaust manifold, it receives the flow of the exhaust gas at the highest temperature in the exhaust system. The thermoelectric converting module (not shown) at the high temperature side of the respective exhaust heat power generation units 22 is heated to reach a high temperature, thus improving the thermoelectric conversion efficiency.

If the generally employed exhaust heat power generation apparatus is arranged in the vicinity of the exhaust manifold, the distortion may become heavier owing to the exhaust gas at the high temperature, resulting in deformation or breakage of the thermoelectric elements and the like. However, the exhaust heat power generation apparatus 21 of this example is structured to restrain the distortion under the heat as much as possible, which can be provided in the vicinity of the exhaust manifold EM. This makes it possible to collect the thermal energy from the exhaust gas at the high temperature with higher efficiency.

As has been described with respect to the embodiment of the invention, it is to be understood that the invention may be embodied in various forms without being limited thereto.

In the aforementioned embodiment, the exhaust heat power generation apparatus has been applied to an automobile. However, it may be applied to other structure that includes an internal combustion engine that discharges the exhaust gas.

In this embodiment, 16 or 12 exhaust heat power generation units are provided to form the exhaust heat power generation apparatus. However, the number of the exhaust heat power generation units may be set to an arbitrary value so long as those units are appropriately arranged in the peripheral and longitudinal directions in consideration with the space and configurations for such arrangement.

In the aforementioned embodiment, the temperature of the exhaust heat power generation apparatus is kept uniform irrespective of the position at either upstream or downstream. This may be realized by arranging the heat exchange member having each pitch among fins of the heat exchange fin reduced as it proceeds downstream. This may also be realized by forming the heat exchange member with the material exhibiting the thermal conductivity that becomes higher as it proceeds downstream. Alternatively, this may be realized by providing the heat exchange member having fins with different pitches and being formed of the material with different thermal conductivity.

In the aforementioned embodiment, the respective members constituting the system through which the thermal energy is transferred is formed of aluminum, and each of the divided exhaust pipes is formed of stainless steel. The members for such system may be formed of the other material exhibiting higher thermal conductivity. Each of the divided exhaust pipes may be formed of the other material exhibiting lower thermal expansion ratio.

In the aforementioned embodiment, the heat exchange members are provided at the high temperature end surface of the thermoelectric converting module, and the cooling unit is provided at the low temperature end surface thereof. Such member as an insulating plate may be interposed between the heat exchange member and the cooling unit.

In this embodiment, not only the cooling unit of water-cooling type but also air-cooling type may be employed.

The exhaust heat power generation apparatus of the invention makes it possible to reduce the influence of the distortion caused under the heat, providing improved thermoelectric conversion efficiency.

## Claims

1. An exhaust heat power generation apparatus comprising:
a thermoelectric converting unit (13) that converts thermal energy of exhaust gas into electric energy;
and
a cooling unit (8) provided on the other surface of the thermoelectric converting unit (13) to cool the thermoelectric converting unit (13),
the exhaust heat power generation apparatus comprises a heat exchange unit (12) provided on one surface of the thermoelectric converting unit (13) to conduct the thermal energy of the exhaust gas that flows through an exhaust pipe (5), and the exhaust heat power generation apparatus being
**characterized in that** the cooling unit (8) has a rigidity set to a highest value among those of the thermoelectric converting unit (13), the heat exchange unit (12) and the cooling unit (8).

2. The exhaust heat power generation apparatus according to claim 1, wherein:
the heat exchange unit (12) includes a heat exchange fm (12b) for conducting the thermal energy of the exhaust gas and a base (12a) having one surface on which the heat exchange unit (12) is placed, and the other surface on which the thermoelectric converting unit (13) is placed;
the exhaust pipe (5) includes a main body that forms a frame of an exhaust passage to which the base (12a) is attached, and the heat exchange fin (12b) provided therein;
the exhaust passage is constructed by the exhaust pipe (5) and the heat exchange unit (12); and
the base (12a) has a rigidity set to a highest value in a structure of the exhaust passage.

3. The exhaust heat power generation apparatus according to claim 2, wherein the main body of the exhaust pipe (5) is formed of a material exhibiting a thermal expansion ratio lower than that of the heat exchange unit (12).

4. The exhaust heat power generation apparatus according to claim 3, wherein the main body of the exhaust pipe (5) is formed of a stainless steel.

5. The exhaust heat power generation apparatus according to claim 2 or 3, wherein:
the main body of the exhaust pipe (5) is provided in a center of the exhaust heat power generation apparatus, the thermoelectric converting unit (13) is provided on an outer periphery of the heat exchange unit (12) attached to the main body of the exhaust pipe (5), and the cooling unit (8) is provided on an outer periphery of the thermoelectric converting unit (13);
an elastic member (14) is provided on an outer side of the cooling unit (8); and
an elastic system for fixing the thermoelectric converting unit (13) is formed, in which a pressure is applied to the cooling unit (8) externally by the elastic member (14).

6. The exhaust heat power generation apparatus according to claim 5, wherein:
the thermoelectric converting unit (13) includes a module formed of a plurality of thermoelectric elements; and
a unit of the elastic system is structured based on the module.

7. The exhaust heat power generation apparatus according to claim 5 or 6, wherein the elastic member (14) includes a spring and a compression member which are one of in point contact and line contact with each other.

8. The exhaust heat power generation apparatus according to claim 2, wherein the heat exchange fin (12b) in the exhaust pipe (5) has different pitches among fins thereof.

9. The exhaust heat power generation apparatus according to claim 8, wherein the heat exchange fin (12b) is formed of a material partially exhibiting different heat conductivities.

10. The exhaust heat power generation apparatus according to claim 2 or 7, wherein each of the heat exchange unit (12) and the main body of the exhaust pipe (5) has a configuration such that a direction in which the base (12a) of the heat exchange unit (12) deforms becomes opposite to a direction in which a contacting surface of the main body of the exhaust pipe (5) deforms, the contacting surface contacting the base (12a) of the heat exchange unit (12).

## Patentansprüche

1. Vorrichtung zur Engergieerzeugung aus Abgaswärme mit:
einer thermoelektrischen Wandlereinheit (13), welche thermische Energie des Abgases in elektrische Energie umwandelt;
einer Kühleinheit (8), welche auf einer Oberfläche der thermoelektrischen Wandlereinheit (13) angeordnet ist, um die thermoelektrische Wandlereinheit (13) zu kühlen; und
einer Wärmetauschereinheit (12), welche auf einer anderen Oberfläche der thermoelektrischen Wandlereinheit (13) angeordnet ist, um die thermische Energie des Abgases, welches durch eine Abgasleitung (5) strömt, zu leiten, **dadurch gekennzeichnet, dass**
die Kühleinheit (8) eine Steifigkeit hat, welche unter denen der thermoelektrischen Wandlereinheit (13), der Wärmetauschereinheit (12) und der Kühleinheit (8) auf den höchsten Wert gesetzt wird.

2. Vorrichtung zur Engergieerzeugung aus Abgaswärme gemäß Anspruch 1, wobei
die Wärmetauschereinheit (12) eine Wärmetauschrippe (12b) zum Leiten der thermischen Energie des Abgases und einen Basisabschnitt (12a) mit einer Oberfläche, an welcher die Wärmetauschereinheit (12) angeordnet ist, und einer anderen Oberfläche, an der die thermoelektrische Wandlereinheit (13) angeordnet ist, enthält;
die Abgasleitung (5) einen Grundkörper enthält, welcher einen Rahmen eines Abgasdurchgangs bildet, an welchem der Basisabschnitt (12a) befestigt ist, und darin die Wärmetauschrippe (12b) vorgesehen ist;
der Abgasdurchgang durch die Abgasleitung (5) und der Wärmetauschereinheit (12) gebildet wird; und
der Basisabschnitt (12a) eine Steifigkeit hat, welche in dem Aufbau des Abgasdurchgangs auf den höchsten Wert gesetzt wird.

3. Vorrichtung zur Engergieerzeugung aus Abgaswärme gemäß Anspruch 2, wobei der Grundkörper der Abgasleitung (5) aus einem Material gebildet ist, welches ein niedrigeres Wärmedehnungsverhältnis zeigt als das der Wärmetauschereinheit (12).

4. Vorrichtung zur Engergieerzeugung aus Abgaswärme gemäß Anspruch 3, wobei der Grundkörper der Abgasleitung (5) aus einem rostfreien Stahl gebildet ist.

5. Vorrichtung zur Engergieerzeugung aus Abgaswärme gemäß Anspruch 2 oder 3, wobei
der Grundkörper der Abgasleitung (5) in der Mitte der Vorrichtung zur Engergieerzeugung aus Abgaswärme vorgesehen ist, die thermoelektrische Wandlereinheit (13) an einen Außenumfang der an dem Grundkörper der Abgasleitung (5) befestigten Wärmetauschereinheit (12) vorgesehen ist, und die Kühleinheit (8) an einem Außenumfang der thermoelektrischen Wandlereinheit (13) vorgesehen ist;
ein elastisches Teil (14) an einer Außenseite der Kühleinheit (8) vorgesehen ist; und
ein elastisches System zur Befestigung der thermoelektrischen Wandlereinheit (13) ausgebildet ist, in welchem durch das elastische Teil (14) von außen ein Druck auf die Kühleinheit (8) aufgebracht wird.

6. Vorrichtung zur Engergieerzeugung aus Abgaswärme gemäß Anspruch 5, wobei
die thermoelektrische Wandlereinheit (13) ein aus einer Vielzahl von thermoelektrischen Elementen gebildetes Modul enthält; und
eine Einheit des elastischen Systems auf der Basis des Moduls aufgebaut ist.

7. Vorrichtung zur Engergieerzeugung aus Abgaswärme gemäß Anspruch 5 oder 6, wobei das elastische Teil (14) eine Feder und ein Kompressionsteil enthält, welche miteinander entweder in Punktkontakt oder Linienkontakt stehen.

8. Vorrichtung zur Engergieerzeugung aus Abgaswärme gemäß Anspruch 2, wobei die Wärmetauschrippe (12b) in der Abgasleitung (5) unterschiedliche Abstände unter den Rippen hat.

9. Vorrichtung zur Engergieerzeugung aus Abgaswärme gemäß Anspruch 8, wobei die Wärmetauschrippe (12b) aus einem Material gebildet ist, welches teilweise unterschiedliche Wärmeleitfähigkeiten zeigt.

10. Vorrichtung zur Engergieerzeugung aus Abgaswärme gemäß Anspruch 2 oder 7, wobei sowohl die Wärmetauschereinheit (12) als auch der Grundkörper der Abgasleitung (5) eine solche Konfiguration hat, dass eine Richtung, in welche sich der Grundabschnitt (12a) der Wärmetauschereinheit (12) verformt, entgegengesetzt zu einer Richtung wird, in welche sich eine Kontaktfläche des Grundkörpers der Abgasleitung (5) verformt, wobei die Kontaktfläche den Grundabschnitt (12a) der Wärmetauschereinheit (12) berührt.

## Revendications

1. Appareil de production d'énergie thermique de gaz d'échappement comprenant :
une unité de conversion thermoélectrique (13) qui convertit une énergie thermique d'un gaz d'échappement en énergie électrique ; et
une unité de refroidissement (8) pourvue sur l'autre surface de l'unité de conversion thermoélectrique (13) pour refroidir l'unité de conversion thermoélectrique (13),
l'appareil de production d'énergie thermique de gaz d'échappement comprend une unité d'échange thermique (12) pourvue sur une surface de l'unité de conversion thermoélectrique (13) pour conduire l'énergie thermique du gaz d'échappement qui s'écoule à travers un tuyau d'échappement (5), et l'appareil de production d'énergie thermique de gaz d'échappement étant **caractérisé en ce que** l'unité de refroidissement (8) a une rigidité établie à une valeur la plus élevée parmi celles de l'unité de conversion thermoélectrique (13), l'unité d'échange thermique (12) et l'unité de refroidissement (8).

2. Appareil de production d'énergie thermique de gaz d'échappement selon la revendication 1, dans lequel :
l'unité d'échange thermique (12) inclut une ailette d'échange thermique (12b) pour conduire l'énergie thermique du gaz d'échappement et une base (12a) ayant une surface sur laquelle l'unité d'échange thermique (12) est placée, et l'autre surface sur laquelle l'unité de conversion thermoélectrique (13) est placée ;
le tuyau d'échappement (5) inclut un corps principal qui forme un cadre d'un passage d'échappement auquel la base (12a) est attachée, et l'ailette d'échange thermique (12b) y est pourvue;
le passage d'échappement est construit par le tuyau d'échappement (5) et l'unité d'échange thermique (12) ; et
la base (12a) a une rigidité établie à une valeur la plus élevée dans une structure du passage d'échappement.

3. Appareil de production d'énergie thermique de gaz d'échappement selon la revendication 2, dans lequel le corps principal du tuyau d'échappement (5) est formé d'un matériau présentant un taux d'expansion thermique plus bas que celui de l'unité d'échange thermique (12).

4. Appareil de production d'énergie thermique de gaz d'échappement selon la revendication 3, dans lequel le corps principal du tuyau d'échappement (5) est formé d'un acier inoxydable.

5. Appareil de production d'énergie thermique de gaz d'échappement selon la revendication 2 ou 3, dans lequel :
le corps principal du tuyau d'échappement (5) est pourvu dans un centre de l'appareil de production d'énergie thermique de gaz d'échappement, l'unité de conversion thermoélectrique (13) est pourvue sur une périphérie extérieure de l'unité d'échange thermique (12) attachée au corps principal du tuyau d'échappement (5), et l'unité de refroidissement (8) est pourvue sur une périphérie extérieure de l'unité de conversion thermoélectrique (13) ;
un organe élastique (14) est pourvu sur un côté extérieur de l'unité de refroidissement (8) ; et
un système élastique pour fixer l'unité de conversion thermoélectrique (13) est formé, dans lequel une pression est appliquée à l'unité de refroidissement (8) extérieurement par l'organe élastique (14).

6. Appareil de production d'énergie thermique de gaz d'échappement selon la revendication 5, dans lequel :
l'unité de conversion thermoélectrique (13) inclut un module formé d'une pluralité d'organes thermoélectriques ; et
une unité du système élastique est structurée sur la base du module.

7. Appareil de production d'énergie thermique de gaz d'échappement selon la revendication 5 ou 6, dans lequel l'organe élastique (14) inclut un ressort et un organe de compression qui sont l'un d'un contact en point ou contact en ligne l'un avec l'autre.

8. Appareil de production d'énergie thermique de gaz d'échappement selon la revendication 2, dans lequel l'ailette d'échange thermique (12b) dans le tuyau d'échappement (5) a différentes inclinaisons parmi des ailettes correspondantes.

9. Appareil de production d'énergie thermique de gaz d'échappement selon la revendication 8, dans lequel l'ailette d'échange thermique (12b) est formée d'un matériau présentant partiellement des conductivités thermiques différentes.

10. Appareil de production d'énergie thermique de gaz d'échappement selon la revendication 2 ou 7, dans lequel chacun de l'unité d'échange thermique (12) et le corps principal du tuyau d'échappement (5) a une configuration telle qu'une direction dans laquelle la base (12a) de l'unité d'échange thermique (12) se déforme devient opposée à une direction dans laquelle une surface de contact du corps principal du tuyau d'échappement (5) se déforme, la surface de contact contactant la base (12a) de l'unité d'échange thermique (12).
